Europäisches Patentamt

(19) European Patent Office

Office européen des brevets

(11) Veröffentlichungsnummer: **0 210 451**
**A2**

(12) # EUROPÄISCHE PATENTANMELDUNG

(21) Anmeldenummer: 86108918.3

(22) Anmeldetag: 01.07.86

(51) Int. Cl.⁴: **H 01 L 31/02**
**H 01 L 25/04, H 01 L 27/14**

(30) Priorität: 27.07.85 DE 3527001

(43) Veröffentlichungstag der Anmeldung:
04.02.87 Patentblatt 87/6

(84) Benannte Vertragsstaaten:
FR GB NL

(71) Anmelder: TELEFUNKEN electronic GmbH
Theresienstrasse 2
D-7100 Heilbronn(DE)

(72) Erfinder: Schilling, Roland
Im Hengst 7
D-7519 Gemmingen(DE)

(74) Vertreter: Maute, Hans-Jürgen, Dipl.-Ing.
TELEFUNKEN electronic GmbH Theresienstrasse 2
D-7100 Heilbronn(DE)

(54) Solargenerator.

(57) Die Erfindung betrifft einen Solargenerator, bestehend aus separaten und voneinander beabstandeten Halbleiter-Solarzellen mit für den Lichteinfall vorgesehenen Oberflächen und miteinander elektrisch verbundenen Anschlußkontakten für die Oberflächen bzw. für die gegenüberliegenden Rückseiten und mit getrennten Oberflächenabdeckungen für die einzelnen Solarzellen. Dabei sind die Oberflächenabdeckungen so ausgebildet, daß die Abstände zwischen benachbarten Solarzellen, in denen die Anschlußkontakte verlaufen, durch einen Steg überdeckt sind.

FIG. 1a

TELEFUNKEN electronic GmbH
Theresienstr. 2, 7100 Heilbronn

## Solargenerator

Die Erfindung betrifft einen Solargenerator, bestehend
aus separaten und voneinander beabstandeten Halbleiter-
Solarzellen mit für den Lichteinfall vorgesehenen Oberflächen und miteinander elektrisch verbundenen Anschlußkontakten für die Oberflächen bzw. für die gegenüberliegenden Rückseiten und mit getrennten Oberflächenabdeckungen für die einzelnen Solarzellen.

Solargeneratoren bestehen aus zusammengeschalteten einzelnen Solarzellen, die mittels Anschlußkontakten parallel
oder seriell verschaltet sein können. Die so verschalteten Solarzellen werden durch geeignete Abdeckmaterialien
wie z.B. Glas hermetisch gekapselt.

Für Raumfahrt-Solarzellen und Generatoren ist es unerläßlich, die Kapselung zwischen benachbarten Solarzellen im
Bereich der elektrischen Anschlußkontakte aufgrund der
relativ großen Temperaturschwankungen nicht hermetisch
vorzunehmen, um den verschiedenen Temperaturkoeffizienten
hinsichtlich der Ausdehnung Rechnung tragen zu können.
Deshalb werden in diesen Bereichen die elektrischen Anschlußkontakte elastisch verformbar ausgebildet.

Es hat sich nun gezeigt, daß insbesondere hoher atomarer
Sauerstoffgehalt in einer bevorzugten Flughöhe Verursacher
für die Zerstörung der elektrischen Anschlußkontakte ist,
die beispielsweise aus Silber hergestellt sind.

Deshalb liegt der vorliegenden Erfindung die Aufgabe zugrunde, eine Struktur für einen Solargenerator anzugeben, die eine längere Lebensdauer für Raumfahrt-Solargeneratoren garantiert.

Diese Aufgabe wird erfindungsgemäß dadurch gelöst, daß die Oberflächenabdeckungen so ausgebildet sind, daß die Abstände zwischen benachbarten Solarzellen, in denen die Anschlußkontakte verlaufen, durch einen Steg überdeckt sind.

Weitere vorteilhafte Ausgestaltungen der Erfindung ergeben sich aus den Unteransprüchen.

Der erfindungsgemäße Solargenerator hat den wesentlichen Vorteil, daß zu seiner Herstellung die bereits in der Raumfahrt qualifizierten Materialien wie Deckglas und Deckglaskleber verwendet werden können.

Ausführungsbeispiele der Erfindung sind in den Figuren dargestellt und werden im folgenden näher beschrieben:

Es zeigen:

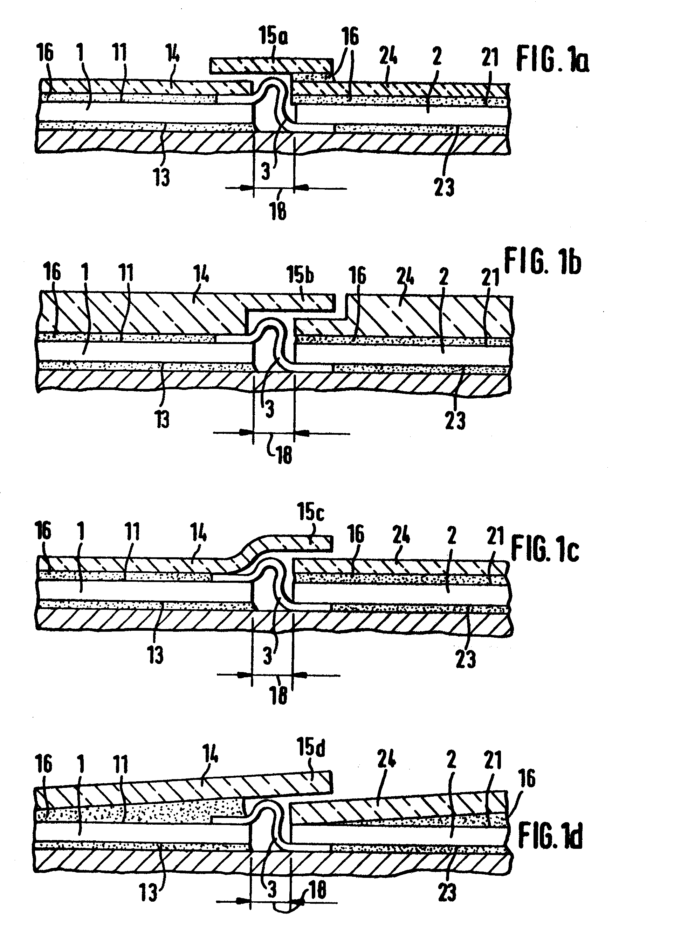

Figur 1 a    Die Struktur eines Solargenerators mit einem als gesondertes Element ausgebildeten Steg 15 a.

Figur 1 b    Die Struktur eines Solargenerators mit einem in der Ebene der Oberflächenabdeckung befindlichen Steg 15 b.

Figur 1 c       Die Struktur eines Solargenerators mit
einem s-förmigen Steg 15 c.

Figur 1 d       Die Struktur eines Solargenerators mit
einem rampenförmigen Steg 15 d.

Die in Figur 1 a gezeigte Struktur eines Solargenerators
zeigt zwei separate, dotierte Halbleitergrundkörper 1 und
2. Auf den dem Lichteinfall ausgesetzten Oberflächen 11
bzw. 21 ist ein Anschlußkontakt 3 angeordnet, der in der
Regel auf den Oberflächen 11 bzw. 21 fingerförmig ausgestaltet ist und der Verschaltung der einzelnen Solarzellen zu entsprechenden Solarmodulen mit den entsprechenden Rückseitenkontakten 13 bzw. 23 dient. Bei der in Figur 1 a gezeigten Verschaltungsart handelt es sich um
eine Serienschaltung. Prinzipiell sind jedoch auch Parallelschaltungen mit dem Anschlußkontakt 3 möglich, da der
im Verbindungsbereich zweier unmittelbar benachbarten
Solarzellen befindliche Teil des Anschlußkontaktes elastisch verformbar ist.

Auf den Oberflächen 11 bzw. 21 befindet sich ein Abdeckmaterial 14 bzw. 24, welches vorzugsweise aus Glas besteht und durch einen auf diesem aufgebrachten Steg 15 a
den Anschlußkontakt 3 über dem Abstand 18 zwischen benachbarten Solarzellen überdeckt, zum Schutz vor schädlichen,
den Anschlußkontakt zerstörender Einflüsse wie beispielsweise atomarem Sauerstoff in hoher Konzentration.

Die Oberflächenabdeckungen 14 bzw. 24 sowie der Steg 15 a
werden durch einen Deckglaskleber 16 auf den einzelnen
Solarzellen bzw. aufeinander befestigt.

Die in Figur 1 b gezeigte Struktur eines Solargenerators stellt eine Modifikation des in Figur 1 a gezeigten Solargenerators dar. Insbesondere ist der Steg 15 b, für die Abdeckung des Abstandes 18, homogen mit der Oberflächenabdeckung 14 in einer Ebene liegend ausgebildet. Alle anderen Elemente sind mit den in Figur 1 a gezeigten identisch.

In Figur 1 c ist die Struktur einer Solarzelle gezeigt, bei der der Steg 15 c über dem Abstand 18 gegenüber der Oberflächenabdeckung 14 erhöht ausgebildet ist und einen s-förmigen Verlauf hat.

Die Figur 1 d zeigt eine weitere Modifikation der Ausgestaltung des Stegs, der dort zusammen mit den Oberflächenabdeckungen 14 bzw. 24 zusammenhängend ausgestaltet ist und auf dem Deckglaskleber 16, der hier im Querschnitt keilförmig verläuft, aufgebracht ist, so daß sich Oberflächenabdeckungen 14, 24 samt zugehörigem Steg 15 d schuppenförmig überdecken.

Als Deckglaskleber 16 kann ein Zwei-Komponentenkleber auf der Basis von Silicon verwendet werden, der im Handel unter dem Namen Silicon-Kautschuk erhältlich ist.

TELEFUNKEN electronic GmbH
Theresienstr. 2, 7100 Heilbronn

Heilbronn, den 16.07.85
T/E7-HN-Se-gä    HN 85/35

## Patentansprüche

1) Solargenerator, bestehend aus separaten und voneinander beabstandeten Halbleiter-Solarzellen (1, 2) mit für den Lichteinfall vorgesehenen Oberflächen (11, 21) und miteinander elektrisch verbundenen Anschlußkontakten (3) für die Oberflächen bzw. für die gegenüberliegenden Rückseiten (13 bzw. 23) und mit getrennten Oberflächenabdeckungen für die einzelnen Solarzellen, dadurch gekennzeichnet, daß die Oberflächenabdeckungen (14, 24) so ausgebildet sind, daß die Abstände (18) zwischen benachbarten Solarzellen, in denen die Anschlußkontakte (3) verlaufen, durch einen Steg (15) überdeckt sind.

2) Solargenerator nach Anspruch 1, dadurch gekennzeichnet, daß der Steg als gesondertes Element (15 a) auf der Oberflächenabdeckung (14, 24) angeordnet ist.

3) Solargenerator nach einem der vorangehenden Ansprüche, dadurch gekennzeichnet, daß der Steg (15 b,c,d) homogen mit der Oberflächenabdeckung (14, 24) ausgebildet ist.

4) Solargenerator nach einem der vorangehenden Ansprüche, dadurch gekennzeichnet, daß das Abdeckmaterial (14, 24) aus Glas besteht.

5) Solargenerator nach einem der vorangehenden Ansprüche, dadurch gekennzeichnet, daß der Steg (15 b) in einer Ebene mit der Oberflächenabdeckung (14, 24) liegt.

6) Solargenerator nach einem der vorangehenden Ansprüche, dadurch gekennzeicnet, daß der Steg als s-förmige Zunge (15 c) ausgebildet ist.

7) Solargenerator nach einem der vorangehenden Ansprüche, dadurch gekennzeichnet, daß der Steg als überdeckende Rampe (15 d) schuppenförmig die einzelnen Solarzellen überdeckt.

0210451

**FIG. 1a**

16  1  11  14  15a  16  24  2  21

13  3  23

18

**FIG. 1b**

16  1  11  14  15b  16  24  2  21

13  3  23

18

**FIG. 1c**

16  1  11  14  15c  16  24  2  21

13  3  23

18

**FIG. 1d**

16  1  11  14  15d  24  2  21  16

13  3  18  23